(19) Europäisches Patentamt
European Patent Office
Office européen des brevets

(11) **EP 4 086 699 A1**

(12) **EUROPEAN PATENT APPLICATION**

(43) Date of publication:
**09.11.2022 Bulletin 2022/45**

(21) Application number: **21172006.5**

(22) Date of filing: **04.05.2021**

(51) International Patent Classification (IPC):
***G02F 1/355*** (2006.01)    ***H01L 35/00*** (2006.01)

(52) Cooperative Patent Classification (CPC):
**G02F 1/355; H01L 35/28;** G02F 2203/15

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Max-Planck-Gesellschaft zur Förderung der Wissenschaften e.V.**
**80539 München (DE)**

(72) Inventors:
• **YORDANOV, Petar**
  **70569 Stuttgart (DE)**

• **PRIESSNITZ, Tim**
  **70569 Stuttgart (DE)**
• **KIM, Min-Jae**
  **70569 Stuttgart (DE)**
• **KAISER, Stefan**
  **70569 Stuttgart (DE)**
• **KEIMER, Bernhard**
  **70569 Stuttgart (DE)**

(74) Representative: **Lambsdorff & Lange Patentanwälte Partnerschaft mbB Grillparzerstraße 12A 81675 München (DE)**

(54) **AN ELECTROMAGNETIC RADIATION SOURCE AND METHOD FOR THE GENERATION OF TERAHERTZ RADIATION BASED ON THE TRANSVERSE THERMOELECTRIC EFFECT**

(57)    An electromagnetic radiation source (10; 40), comprising: a material (1; 41) having an anisotropic Seebeck coefficient configured to generate a transverse current pulse by means of the transverse thermoelectric effect upon laser pulse irradiation, wherein the electromagnetic radiation is generated by the change in time of the current pulse.

Fig. 1

EP 4 086 699 A1

**Description**

TECHNICAL FIELD

The present disclosure is related in general to the technical field of generation of electromagnetic radiation and in particular to the generation of terahertz radiation by utilizing the off-diagonal or transverse thermoelectric effect.

BACKGROUND

The search for efficient sources for the THz frequency range ($\sim$ 0.1 - 100 THz) (1 THz = 1 x $10^{12}$ Hz) is currently very actively pursued in both science and technology. The strong interest is driven by the significant benefits of THz radiation in fields such as spectroscopy, object imaging, fast data transfer, etc., which relate to fundamental science investigations, medicine, security, communications, and other specialized applications. However, the realization of THz sources is associated with significant challenges. Most currently available sources require specialized equipment and conditions such as expensive high-quality single crystals (some of them toxic), lithography for micro- or nano-structuring, application of external fields, cryogenics, or cumbersome system adjustment procedures. In addition, the output power of the most commonly used THz sources is limited and difficult to enhance.

For these and other reasons there is a need for the present disclosure.

SUMMARY

A first aspect of the present disclosure is related to an electromagnetic radiation source comprising a material having an anisotropic Seebeck coefficient and being configured to generate a transverse current pulse by means of the off-diagonal or transverse thermoelectric effect upon laser pulse irradiation, wherein the electromagnetic radiation is generated by the change in time of the current.

A second aspect of the present disclosure is related to a method of generating an electromagnetic radiation, the method comprising directing a short-time laser pulse on a material, the material having an anisotropic Seebeck coefficient and being configured to generate a transverse current pulse by means of the off-diagonal or transverse thermoelectric effect upon laser pulse irradiation; and emitting electromagnetic radiation generated by a change in time of the transverse current.

A third aspect of the present disclosure is related to a material, in particular for use in an electromagnetic radiation source, the material having an anisotropic Seebeck coefficient and being configured to generate a transverse current pulse by means of the off-diagonal or transverse thermoelectric effect upon laser pulse irradiation, wherein the electromagnetic radiation is generated by the change in time of the current.

DESCRIPTION OF EMBODIMENTS

It should be mentioned that the term "transverse current" does not imply a current which is perfectly transverse to the temperature gradient. It can also mean a current which is only essentially transverse to the temperature gradient.

According to an embodiment of the electromagnetic radiation source of the first aspect, the material has a two-dimensional crystallographic symmetry, wherein an axis normal to a crystallographic symmetry plane is tilted with respect to the direction of a temperature gradient produced by the laser pulse irradiation. Also a lower symmetry than the two-dimensional symmetry will work.

According to an embodiment of the electromagnetic radiation source of the first aspect, the material is a film or layer or sheet disposed on a surface of a substrate, or a free-standing layer. The thickness of the film can be equal to or less than 500 nm or 100 nm or 60 nm or the thickness of the film is optimized with respect to the penetration depth of the electromagnetic radiation (1 nm = 1 x $10^{-9}$ m). The surface of the substrate may comprise a step-terrace topography.

According to an embodiment of the electromagnetic radiation source of the first aspect, the material is a bulk material.

According to an embodiment of the electromagnetic radiation source of the first aspect, the material has an anisotropic Seebeck coefficient by virtue of its intrinsic or artificial structure. The Seebeck coefficient of the material may have any polarity, i.e. negative, positive, or a combination of both.

According to an embodiment of the electromagnetic radiation source of the first aspect, the material is a material with anisotropic charge carrier transport properties. In particular, the material can be a material having intrinsic anisotropic charge carrier transport properties such as e.g. layered transition metal oxides, or an artificial material, e.g. grown by epitaxy, such as a multi-layer heterostructures material, a superlattice heterostructure, e.g. a semiconductor superlattice heterostructure. The charge carriers may have any polarity, i.e. may be electrons or holes, or a combination of both.

According to an embodiment of the electromagnetic radiation source of the first aspect, the material is a layered transition metal oxide, in particular $PdCoO_2$, $La_{2-x}Sr_xCuO_4$, $PtCoO_2$, $Ca_3Co_4O_9$.

According to an embodiment of the electromagnetic radiation source of the first aspect, a laser spot diameter on the material can in general be in the nm or cm range. In particular, it can be equal to or greater than 100 nm or 1 mm or 1 cm, or is optimized with respect to the material surface area.

According to an embodiment of the electromagnetic radiation source of the first aspect, a micropattern is superimposed onto the material and/or the substrate, e.g. the micropattern forming a grating. The grating may have a grating period corresponding to a wavelength of the emitted electromagnetic radiation (e.g. several few mm to 10 $\mu$m). In particular, the micropattern can be formed by a surface topology of the material or by a surface topology of a substrate on which the material is disposed or by a pattern of a grating material applied to the material. Also possible is that the band-structure of the material is patterned (band-structure engineering), e.g. by epitaxial growth patterning or by dopant patterning, e.g. by forming a dopant profile in the material. The grating can also be formed by removing of material, e.g. by etching.

According to an embodiment of the electromagnetic radiation source of the first aspect, the electromagnetic radiation source further comprises a pulsed laser configured to generate the laser pulse irradiated on the material. The pulsed laser can be any conventional laser source, in particular one or more of a short pulse laser, a solid state laser, a (Ti-)sapphire laser, an erbium laser, a diode laser, a glass fiber laser, or a (tunable) OPA laser. The laser maybe tuned to high absorption in the material. The pulse energy per laser pulse can be equal to or greater than 1 $\mu$J or 10 $\mu$J or 100 $\mu$J or 1 mJ or 10 mJ (1 $\mu$J = 1x10$^{-6}$ J, 1 mJ = 1x10$^{-3}$ J) . The duration of the laser pulse can be equal to or less than 1 ns or 1 ps or 100 fs or 10 fs or 1 fs. (1 ns = 1 x 10$^{-9}$ s, 1 ps = 1 x 10$^{-12}$ s, 1 fs = 1 x 10$^{-15}$ s). The repetition rate of the laser can be equal to or larger than 1Hz or 1kHz or 1GHz (1 kHz = 1x10$^3$ Hz, 1 GHz = 1x10$^6$ Hz).

According to an embodiment of the electromagnetic radiation source of the first aspect, the generated radiation is independent of any possible polarization of the laser light.

According to an embodiment of the electromagnetic radiation source of the first aspect, the electromagnetic radiation is in the GHz or THz frequency range.

According to an embodiment of the electromagnetic radiation source of the first aspect, the emission of the electromagnetic radiation is in transmission direction and in reflection direction.

According to an embodiment of the electromagnetic radiation source of the first aspect, an external voltage and/or a magnetic field is applied to the electromagnetic radiation source.

According to an embodiment of the electromagnetic radiation source of the first aspect, one or more of a coating, a protective layer, a reflective layer, an absorption layer is deposited onto the electromagnetic radiation source.

According to an embodiment of the electromagnetic radiation source of the first aspect, the pump laser wavelength is tuned to optimize the absorption in the material, hence to optimize also the temperature gradient in the material.

Embodiments of the method according to the second aspect can be formed together with any features or embodiments as described in connection with the electromagnetic radiation source of the first aspect.

Embodiments of the material according to the third aspect can be formed together with any features or embodiments as described in connection with the electromagnetic radiation source of the first aspect.


BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.


Fig. 1 shows a schematic illustration of a method for the generation of THz radiation based on the transverse thermoelectric effect.


Fig. 2 comprises Fig. 2a and 2b and shows perspective schematic views of a material exemplifying the conventional Seebeck effect (a) and an anisotropic material exemplifying the transverse thermoelectric effect (b).


Fig. 3 comprises Fig. 3a to 3c and shows a thin film of an anisotropic material deposited on an offcut substrate (a), a layered structure of $PdCoO_2$ (b), and the temperature dependent Seebeck coefficient of $PdCoO_2$ along the main crystallographic axes (c).


Fig. 4 comprises Fig. 4a and 4b and shows a side view of a laser-induced transverse voltage (LITV) setup (a) and a diagram of LITV versus time generated by an excimer laser (b).

Fig. 5 comprises Fig. 5a and 5b and shows a side view of an experimental setup for the generation of terahertz radiation (a) and terahertz signals versus time for two different offcut angles and two THz gating directions probing the THz radiation polarization state via electrooptical sampling(b).

Fig. 6 comprises Fig. 6a and 6b and shows the terahertz signal from a thin film of PdCoO2 compared with that from a ZnTe crystal (a) and the corresponding THz emission frequency spectra (b).

DETAILED DESCRIPTION

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

In the following, a detailed description will be presented of a new method for the generation of THz radiation based on the transverse thermoelectric effect (TTE), which can be realized in a simple experimental scheme by using commercial pulsed lasers and, for example, thin films of materials that exhibit an anisotropic Seebeck coefficient.

Experimental data will be presented that demonstrate THz generation from thin films of $PdCoO_2$ deposited on $Al_2O_3$ offcut substrates. The obtained THz emission is linearly polarized with a bandwidth of at least $v \approx 0.1 - 2.6$ *THz.* A direct comparison of the emitted THz electric field from $PdCoO_2$ thin films with a commercially available THz source - ZnTe (optical rectification) crystal - shows that they are already comparable in magnitude.

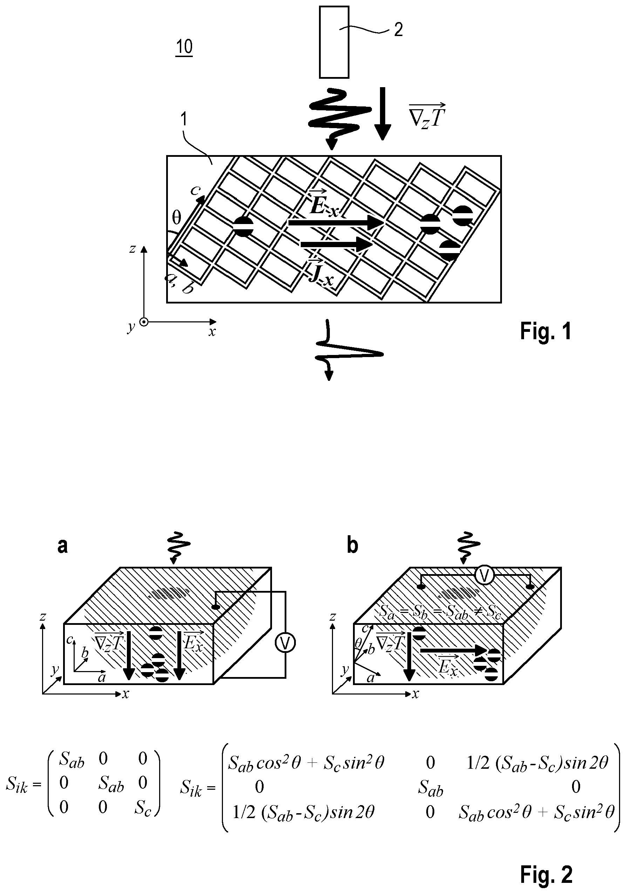

Fig. 1 shows a schematic illustration of a method for the generation of THz radiation based on the transverse thermoelectric effect.

The method involves femtosecond laser pulses, which create an ultrafast transient temperature gradient $\nabla_z T$, and thin films of material 1 with anisotropic Seebeck coefficient (the Seebeck coefficient has different values along at least two of the crystallographic directions $a,b,c$), such as layered transition metal oxides $PdCoO_2$, $La_{2-x}Sr_xCuO_4$, $PtCoO_2$, $Ca_3Co_4O_9$, etc., where $S_a = S_b = S_{ab} \neq S_c$. The orientation of the thin film 1 is such that the main crystallographic axes are non-collinear with respect to the temperature gradient, $\nabla_z T \angle c = \theta$. The THz radiation is generated on the principle of the transverse (or off-diagonal) thermoelectric effect (TTE), as follows (Fig. 1):

**(1)** The femtosecond laser pulse creates an ultrafast transient temperature gradient $\nabla_z T$ in the thin film.
**(2)** The temperature gradient triggers a quasi-instant directed diffusion of hot charge carriers (electrons or holes, or an asymmetric combination of both), equivalent to an electric current - an in-plane current along the projection of the tilted c axis onto the film surface, i.e. perpendicular to the temperature gradient $j_x \perp \nabla_z T$ - "transverse current". This process is driven by the transverse thermoelectric effect, where the Seebeck coefficient anisotropy $(S_{ab} - S_c)$

establishes a thermoelectric field component $E_x = \frac{sin2\theta}{2}(S_{ab} - S_c)\nabla_z T,$ perpendicular to the temperature

gradient $E_x \perp \nabla_z T$. **(3)** The abrupt changes in the electric current density $j_x$ with time (acceleration/deceleration of charge carriers) induced by the femtosecond laser pulse (at its arrival, passing through, and leaving the sample) are sources of THz radiation $dj_x/dt \sim E_{THz}$, i.e. a dipole radiation.

The TTE THz generation is not encumbered by the typical limitations of available THz sources. Specifically, it does not require an external voltage or magnetic field, cryogenics, phase-matching conditions, or expensive high-quality crystals. Since the TTE method is based on thin films 1 of metallic compounds with anisotropic Seebeck coefficients, layered transition metal oxides can offer potentially a large choice. This should allow realization of simple and cost effective THz generation with a broad bandwidth, highly scalable (femtosecond laser power / THz radiation power) output power, and a large number of parameters for further optimization and manipulation of the THz emission characteristics.

Fig. 2 comprises Fig. 2a and 2a and illustrates the conventional Seebeck effect in a material exposed to a temperature gradient (a), and the transverse thermoelectric effect in an anisotropic material (b).

The conventional thermoelectric Seebeck effect results in the buildup of a thermoelectric field $E_z = S \nabla_z T,$ where $S$ is the Seebeck coefficient, parallel to the temperature gradient $\nabla_z T$ (Fig. 2a). The effect can emerge in any material, regardless of its symmetry, as long as it contains mobile electric charge carriers and a temperature difference across the sample is present. The TTE (or off-diagonal thermoelectric effect) is relatively less studied. It occurs in anisotropic materials, with $S_a = S_b = S_{ab} \neq S_c$ (or lower symmetry), in a non-collinear geometry with respect to the temperature gradient $\nabla_z T \angle c = \theta$ (Fig. 2b) [2,3,4]. In this case, the thermoelectric field has two components - one collinear with the temperature gradient due to the conventional Seebeck effect, and one transverse to the temperature gradient $E_x \perp \nabla_z T$ due to the non-zero off-diagonal elements in the Seebeck coefficient tensor.

Fig. 2a illustrates the conventional Seebeck effect in materials exposed to a temperature gradient. The thermoelectric field arises due to the thermal diffusion of charge carries from the hot to the cold end, in direction parallel to the temperature gradient $E_z \parallel \nabla_z T$. The Seebeck tensor (shown below Fig. 2a) has only diagonal components.

Fig. 2b illustrates the transverse thermoelectric effect in anisotropic materials ($S_a = S_b = S_{ab} \neq S_c$) in a non-collinear geometry of the crystal $c$ axis with respect to the temperature gradient ($\nabla_z T \angle c = \theta$). In this case, the Seebeck tensor (shown below Fig. 2b) has non-zero off-diagonal elements resulting in thermoelectric field with component perpendicular to the temperature gradient ($E_x \perp \nabla_z T$).

The field components in the case of the TTE are as follows:

$$\begin{pmatrix} E_x \\ E_y \\ E_z \end{pmatrix} = \begin{pmatrix} S_{ab}cos^2\theta + S_c sin^2\theta & 0 & (S_{ab} - S_c)\frac{sin2\theta}{2} \\ 0 & S_{ab} & 0 \\ (S_{ab} - S_c)\frac{sin2\theta}{2} & 0 & S_{ab}sin^2\theta + S_c cos^2\theta \end{pmatrix} \cdot \begin{pmatrix} 0 \\ 0 \\ \nabla_z T \end{pmatrix}$$

$$= \begin{pmatrix} \frac{sin2\theta}{2}(S_{ab} - S_c) \nabla_z T \\ 0 \\ (S_{ab}sin^2\theta + S_c cos^2\theta) \nabla_z T \end{pmatrix} \quad (1)$$

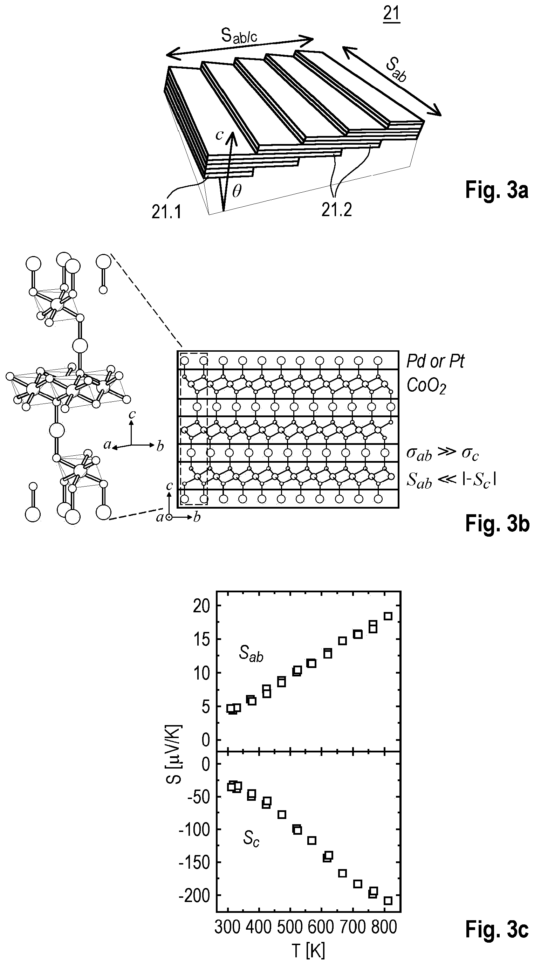

Fig. 3 comprises Fig. 3a to 3c and shows a thin film of an anisotropic material ($S_a = S_b = S_{ab} \neq S_c$) deposited on offcut substrate, with an offcut angle $\theta$ (a), a layered crystal structure of $PdCoO_2$ with a highly anisotropic and ambipolar Seebeck coefficient (b), and the temperature dependent Seebeck coefficient of $PdCoO_2$ along the main crystallographic axes - in-plane ($ab$), and along the $c$ axis (c) [5].

The TTE can be realized in thin films of anisotropic materials deposited on offcut substrates, which forces the growth of the crystal $c$ axis at an angle $\theta$ with respect to the surface normal. A temperature gradient applied along the surface normal then generates a thermoelectric voltage along the offcut ($ab/c$) direction (Fig. 3a). The material investigated here is $PdCoO_2$ (Fig. 3b) - a material with a strongly anisotropic and ambipolar Seebeck coefficient (Fig. 3c) [5].

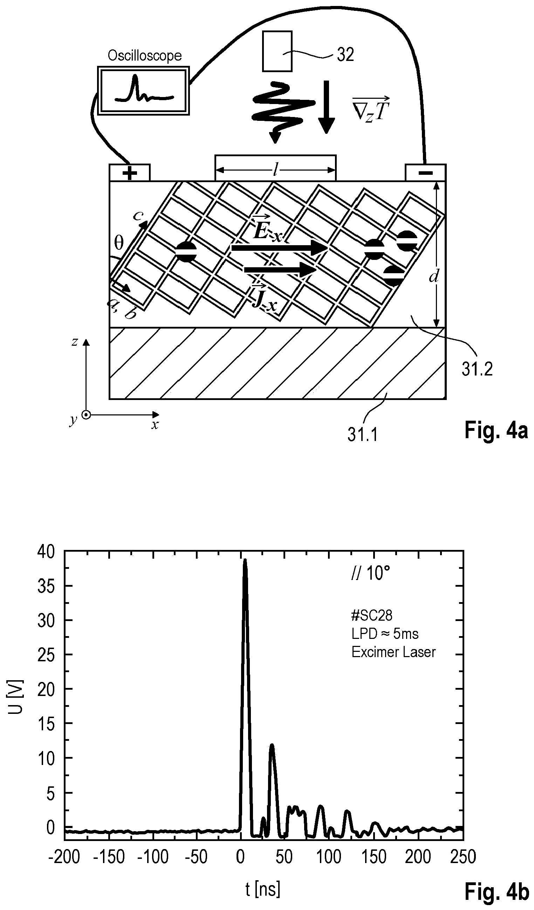

Fig. 4 comprises Fig. 4a and 4b and shows a side view of a laser-induced transverse voltage (LITV) setup (a) and a diagram of LITV versus time generated by an excimer laser (b).

When the temperature gradient in such a TTE thin film structure is generated by a laser pulse (Fig. 4a), the resulting laser-induced transverse voltage (LITV) can be substantial - tens or even hundreds of volts [2,4,5]. The voltage components are given by:

$$U_x = E_x l = \frac{sin2\theta}{2}(S_{ab} - S_c)\frac{\Delta_z T}{d}l \qquad (2)$$

(the transverse component)

$$U_y = 0 \qquad (3)$$

(by symmetry)

$$U_z = E_z d = (S_{ab}sin^2\theta + S_c cos^2\theta)\,\Delta_z T \qquad (4)$$

(the conventional Seebeck effect component)

Here $\nabla_z T = \Delta_z T/d$, and $\Delta_z T$ is the temperature difference at the surface and the back side of the film, $d$ is the film thickness, and $l$ is the laser spot diameter on the film surface.

Fig. 4a shows a side view of a laser-induced transverse voltage (LITV) setup. Laser pulses are used to create the temperature gradient. The sample is a thin film ($S_a = S_b = S_{ab} \neq S_c$) deposited on an offcut substrate $\nabla_z T \angle c = \theta$. The result is the generation of a voltage in direction along the projection of the tilted $c$ axis onto the film surface (denoted here by ($x$), or ($ab/c$) in Fig. 3a), and perpendicular to the temperature gradient ($U_x \perp \nabla_z T$).

Fig. 4b shows a typical LITV generated by an excimer laser (wavelength $\lambda$ = 248 $nm$, pulse duration $LPD$ = 5 $ns$, repetition rate $RR$ = 1$Hz$) in PdCoO$_2$ thin film on Al$_2$O$_3$ offcut ($\theta$ = 10°) substrate. The large voltage ($U$ = 40 $V$), and the short response time ($FWHM$ = 7 $ns$), are due to the large ambipolar Seebeck coefficient anisotropy and the high electrical conductivity/thermal diffusivity in this material. The response time thus may be limited by the laser pulse duration. The voltage signal $U(t)$ is measured by using Pt electrical contacts deposited on the film surface and an oscilloscope.

Thus, there are several obvious and important implications of the TTE: (1) Large voltages can be generated in the material with no need for an external source. (2) Since the generated voltage is in the direction perpendicular to the temperature gradient, thin films can be used, which eliminates the need for large and expensive single crystals. (3) The voltage is proportional to the Seebeck coefficient anisotropy ($S_{ab}$ - $S_c$), the offcut angle $\theta$, and the aspect ratio ($l/d$), which can lead to a signal enhancement of ~$10^4$ - $10^5$ compared to the conventional Seebeck effect - i.e. the system is highly scalable.

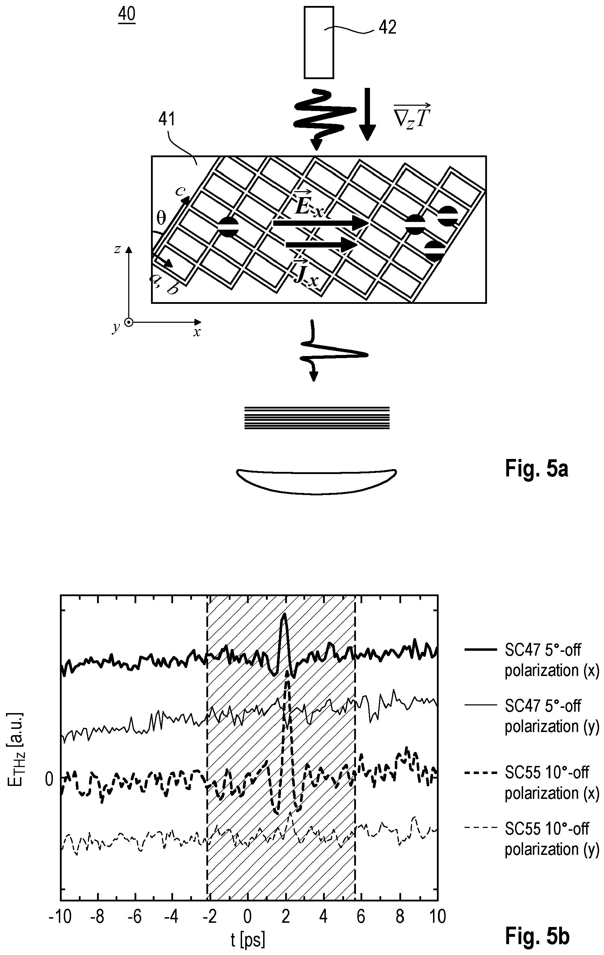

Fig. 5 comprises Fig. 5a and 5b and shows a side view of an experimental setup for the generation of terahertz radiation (a) and terahertz signals versus time for two different offcut angles and two different THz gating directions probing the polarization state of the THz radiation (b).

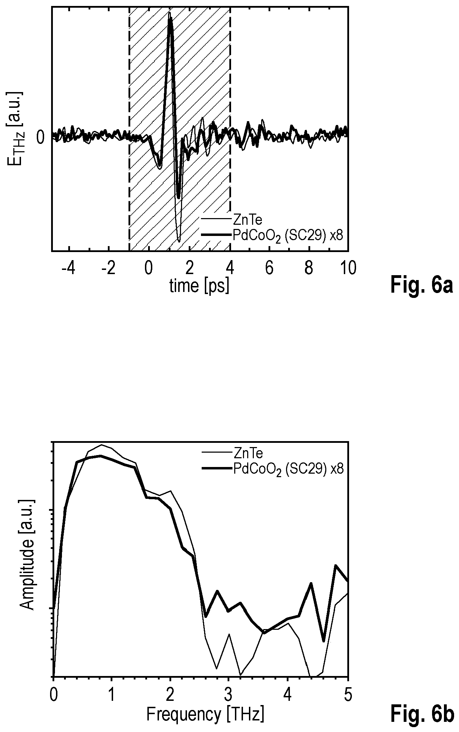

Considering the extremely fast response measured in PdCoO$_2$ (see Fig. 4b), with a reaction time comparable to that of the laser pulse duration, it can be concluded that the reaction time in this material may not be limited by its fundamental physical properties but rather by the laser pulse duration. In order to examine the fundamental limits of the response time in PdCoO$_2$, an experiment was performed by utilizing a femtosecond laser (Fig. 5a), which resulted in an unbiased generation of radiation with a frequency in the range of at least $v \approx$ 0.1 - 2.6 $THz$ (Fig. 5b and Fig. 6).

Fig. 5a shows the experimental setup for the generation of THz emission (transmission mode) based on TTE. Optical laser pulses with characteristics ($LPD \approx$ 100 - 200$fs$, $\lambda$ = 800$nm$, $RR$ = 150 $kHz$, $fluence \approx$ 0.5 $mJ$/cm$^2$) were used. It is to be noted that no external bias is applied to the samples.

Fig. 5b shows the THz signal (emitted field) versus time (relative units) of PdCoO$_2$ films on Al$_2$O$_3$ offcut substrates. Two different types of thin films were investigated - with offcut angles $\theta$ = 5° and 10°, respectively. The emitted THz radiation shows linear polarization - results for two different THz field gating directions probing the polarization state of the THz radiation are shown - ($x$) corresponding to the offcut direction $U_x, E_x$, and ($y$), which is along the in-plane ($ab$) and is forbidden by symmetry $U_y$ = 0, $E_y$ = **0** (Eqs. 1-4) .

Fig. 5b shows the first experimental data set of the generation of THz radiation due to the TTE. The dependence of the signal strength on the offcut angle $\theta$ = 5°, 10°, as well as the linear polarization state of the THz field confirm that the origin of the emission is indeed the TTE, according to Eqs. 1-4. Furthermore, control experiments were performed with a PdCoO$_2$ film deposited on normal substrate ($\theta$ = **0°**), and with a thin film of pure Pd deposited on offcut substrate ($\theta$ = 10°), which both yielded no emission in the entire measured frequency range. The THz field strength showed only a negligible dependence on the laser pump polarization.

As will be seen in the following a direct comparison of the emitted terahertz field of the PdCoO$_2$ films with a commercially available THz source - ZnTe crystal (optical rectification source) (Fig. 6) showed that they are already comparable in magnitude in the initial testing phase.

Fig. 6 comprises Fig. 6a and 6b and shows the terahertz signal from a thin film of PdCoO2 compared with that from a ZnTe crystal (a) and the corresponding THz emission frequency spectra (b).

Fig. 6a illustrates a comparison of the emission field from a commercially available ZnTe optical rectification crystal and a thin film of $PdCoO_2$ on offcut substrate. (The comparison is done by replacing the $PdCoO_2$ thin film with the ZnTe crystal, Fig. 5a). The signal strength from the $PdCoO_2$ in this data set is 8 times smaller compared to that of the ZnTe source. However, in the course of further work, data were collected from other $PdCoO_2$ thin film samples (samples are still in testing phase - not yet optimized) that show much larger signal levels, of just 4 times smaller compared to ZnTe. It should further be noted that the $PdCoO_2$ films can be further optimized - reference is made to points 1-12 in the text below.

Fig. 6b shows the corresponding THz emission frequency domain. It should be noted also that the detector (also based on ZnTe) sensitivity ($v \approx 0.1 - 2.6\ THz$) and the laser pulse duration may limit the obtained emission bandwidth of $PdCoO_2$.

A preliminary analysis indicates that the magnitude of the generated field $E_{THz}$ and the fast thermoelectric field reaction are facilitated by the large Seebeck coefficient anisotropy and the large electron mobility and thermal diffusivity in $PdCoO_2$. In a complementary proof-of-concept experiment with thin films of $La_{2-x}Sr_xCuO_4$, THz emission was observed with a smaller signal level likely due to the smaller ($S_{ab}$ - $S_c$) and carrier mobility/thermal diffusivity compared to $PdCoO_2$.

Below is a list with important aspects and advantages over other existing methods for THz generation:

**1.** The TTE method is relatively simple. Since the key requirement is a material with an anisotropic Seebeck coefficient, the relatively large number of available layered transition metal oxides can offer here a potentially large choice.

**2.** The specificity of the TTE method allows one to take the full advantage of thin film technology. By varying the film material, substrate material (epitaxial strain), chemical doping, and/or by engineering a combination of materials, the THz emission field characteristics can be optimized.

**3.** The variation of the experimental parameters: film thickness $d$, offcut angle $\theta$, laser fluence (laser power/laser spot diameter $l$), represent additional parameters to influence the THz emission.

**4.** As ($S_{ab}$ - $S_c$), and all other relevant quantities, such as the electric conductivity and thermal diffusivity, are usually temperature dependent (Fig. 3c), cooling or heating can be used to tune the emitted THz signal strength, and/or the THz bandwidth.

**5.** As the anisotropy in the Seebeck coefficient creates an intrinsic field, the THz generation does not generally require an external voltage source. It is, however, still possible to apply a bias voltage (and/or magnetic field) to the films, which creates a further opportunity to manipulate the emission characteristics.

**6.** Other means to manipulate the signal strength include microstructuring or micropatterning, so that the outgoing emission is enhanced by interference. Similarly, micro-antenna structures can be used for more efficient THz emission.

**7.** Based on the specificity of TTE, the emission is expected to be highly linearly polarized. This expectation was confirmed in the experiments on $PdCoO_2$.

**8.** So far, the measurements on $PdCoO_2$ thin films indicate that the emission spectrum (0.1-2.6$THz$) and THz field strength are comparable to the most commonly used table top source, ZnTe, but the method may even yield a broader emission bandwidth; this requires further experiments.

**9.** The power of the emitted THz pulse scales with the one of the optical laser pulse. Since $PdCoO_2$ is a highly metallic compound, it is expected to be stable against laser induced damage even at high fluence, thus presumably allowing a high THz output power.

**10.** The small dimension of the TTE THz source allows for the engineering of compact THz integrated (on-chip) scalable devices.

**11.** The TTE method imposes no limitations or constraints on the laser spot position or the laser spot size on the surface of the material.

**12.** It is possible that a coating - a protective layer, and/or a reflective, and/or an absorption layer is deposited onto the material, and/or the pump laser wavelength is tuned to optimize the absorption in the material, hence also to optimize the resulting temperature gradient in the material.

Although the disclosure has been shown and described with respect to one or more implementations, equivalent alterations and modifications will occur to others skilled in the art based at least in part upon a reading and understanding of this specification and the annexed drawings. The disclosure includes all such modifications and alterations and is limited only by the concept of the following claims. In particular regard to the various functions performed by the above described components (e.g., elements, resources, etc.), the terms used to describe such components are intended to correspond, unless otherwise indicated, to any component which performs the specified function of the described component (e.g., that is functionally equivalent), even though not structurally equivalent to the disclosed structure which performs the function in the herein illustrated exemplary implementations of the disclosure. In addition, while a particular feature of the disclosure may have been disclosed with respect to only one of several implementations, such feature may be combined with one or more other features of the other implementations as may be desired and advantageous for any given or particular application.

**References**

[1] P. Shumyatsky, R. R. Alfano, J. Biomed. Opt. 16, 033001 (2011).

[2] H. Lengfellner, S. Zeuner, W. Prettl, and K.F. Renk, Europhys. Lett. 25, 375 (1994).

[3] L. R. Testardi, Appl. Phys. Lett. 64, 2347 (1994)

[4] Th. Zahner, R. Schreiner, R. Stierstorfer, O. Kus, S. T. Li, R. Roessler, J. D. Pedarnik, D. Bauerle, and H. Lengfellner, Europhys. Lett. 40, 673 (1997).

[5] P. Yordanov, W. Sigle, P. Kaya, M. E. Gruner, R. Pentcheva, B. Keimer, and H.-U. Habermeier, Phys. Rev. Mater. 3, 085403 (2019).

**Claims**

1. Electromagnetic radiation source (10; 40), comprising:
   a material (1; 41) having an anisotropic Seebeck coefficient and being configured to generate a current pulse by means of the off-diagonal or transverse thermoelectric effect upon laser pulse irradiation, wherein the electromagnetic radiation is generated by the change in time of the current.

2. The electromagnetic radiation source (10; 40) of claim 1, wherein the material (1; 41) has a two-dimensional crystallographic symmetry, wherein an axis normal to a crystallographic symmetry plane is tilted with respect to the direction of a temperature gradient produced by the laser pulse irradiation.

3. The electromagnetic radiation source of claim 1 or 2, wherein the material (21; 31) is a film or sheet or layer (21.2; 31.2) disposed on a surface of a substrate (21.1; 31.1), or a free-standing layer.

4. The electromagnetic radiation source of claim 3, wherein the surface of the substrate (21.1) has an offcut step-terrace topography.

5. The electromagnetic radiation source of claim 3 or 4, wherein the thickness of the film (21.2; 31.2) is equal to or less than 500 nm or 100 nm or 60 nm, or is optimized with respect to the penetration depth of the electromagnetic radiation.

6. The electromagnetic radiation source (10; 40) of any one of the preceding claims, wherein a laser spot diameter on the material (1; 41) is in a range from 100 nm to 10 cm or equal to or greater than 0.5 mm or 1 mm or 1 cm, or is optimized with respect to the material surface.

7. The electromagnetic radiation source of any of the preceding claims, wherein the material has an anisotropic Seebeck coefficient by virtue of its intrinsic or artificial structure, in particular the Seebeck coefficient comprising any polarity, i.e. negative, positive, or a combination of both.

8. The electromagnetic radiation source of any of the preceding claims, wherein the material is a material comprising anisotropic charge carrier transport properties, in particular a material having intrinsic anisotropic charge carrier transport properties.

9. The electromagnetic radiation source of any of the preceding claims, wherein the material (21.2) is a layered transition metal oxide, in particular $PdCoO_2$, $La_{2-x}Sr_xCuO_4$, $PtCoO_2$, or

10. The electromagnetic radiation source of any of claims 1 to 8, wherein the material is a multilayer heterostructure or a superlattice, in particular a semiconductor superlattice.

11. The electromagnetic radiation source of any one of the preceding claims, wherein a micropattern is superimposed to the material, in particular the micropattern comprising a grating, in particular comprising a grating period corresponding to a wavelength of the emitted electromagnetic radiation.

12. The electromagnetic radiation source of claim 11, wherein the micropattern is formed by a surface topology of the material and/or by a surface topology of a substrate on which the material is disposed or by a pattern of a grating material applied to the material or by a dopant profile formed in the material.

13. The electromagnetic radiation source (10; 40) of any one of the preceding claims, further comprising a pulsed laser (2; 32; 42) configured to generate the laser pulse irradiated on the material (1; 21; 31).

14. The electromagnetic radiation source (10; 40) of claim 13, wherein the pulse energy per laser pulse is equal to or greater than 1 $\mu$J or 10 $\mu$J or 100 $\mu$J or 1 mJ or 10 mJ.

15. The electromagnetic radiation source (10; 40) of claim 13 or 14, wherein the duration of the laser pulse is equal to or less than 1 ns or 1 ps or 100 fs or 10 fs or 1 fs.

16. The electromagnetic radiation source (10; 40) of any of the preceding claims, wherein the electromagnetic radiation is in the GHz or THz frequency range.

17. A method of generating an electromagnetic radiation, the method comprising:

   directing a short-time laser pulse on a material, the material having an anisotropic Seebeck coefficient configured to generate a transverse current pulse by means of a transverse thermoelectric effect upon laser pulse irradiation; and
   emitting electromagnetic radiation generated by a change in time of the transverse current.

18. A material (1; 21; 31; 41), in particular for use in an electromagnetic radiation source, the material having an anisotropic Seebeck coefficient and being configured to generate a transverse current pulse by means of the transverse thermoelectric effect upon laser pulse irradiation, wherein the electromagnetic radiation is generated by the change in time of the current.

19. The material (21) of claim 18, wherein
   the material (21.2) is a layered transition metal oxide, in particular $PdCoO_2$, $La_{2-x}Sr_xCuO_4$, $PtCoO_2$, or $Ca_3Co_4O_9$.

Fig. 1

$$S_{ik} = \begin{pmatrix} S_{ab} & 0 & 0 \\ 0 & S_{ab} & 0 \\ 0 & 0 & S_c \end{pmatrix} \quad S_{ik} = \begin{pmatrix} S_{ab}\cos^2\theta + S_c\sin^2\theta & 0 & 1/2\ (S_{ab}-S_c)\sin 2\theta \\ 0 & S_{ab} & 0 \\ 1/2\ (S_{ab}-S_c)\sin 2\theta & 0 & S_{ab}\cos^2\theta + S_c\sin^2\theta \end{pmatrix}$$

Fig. 2

Fig. 3a

$Pd\ or\ Pt$

$CoO_2$

$\sigma_{ab} \gg \sigma_c$

$S_{ab} \ll |\text{-}S_c|$

Fig. 3b

Fig. 3c

Fig. 4a

Fig. 4b

Fig. 5a

Fig. 5b

**Fig. 6a**

**Fig. 6b**

Europäisches
Patentamt

European
Patent Office

Office européen
des brevets

# EUROPEAN SEARCH REPORT

Application Number

EP 21 17 2006

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | XIONG FEI ET AL: "Doping dependence of laser-induced transverse thermoelectric voltages in the perovskite Nd2-xCexCuO4thin f", APPLIED PHYSICS A MATERIALS SCIENCE & PROCESSING, SPRINGER BERLIN HEIDELBERG, BERLIN/HEIDELBERG, vol. 120, no. 2, 5 June 2015 (2015-06-05), pages 717-723, XP035516334, ISSN: 0947-8396, DOI: 10.1007/S00339-015-9246-5 [retrieved on 2015-06-05] | 1-14, 17-19 | INV. G02F1/355 H01L35/00 |
| Y | * the whole document * | 16 | |
| X | ZHANG G-Y ET AL: "A high-performance laser energy meter based on anisotropic Seebeck effect in a strongly correlated electronic thin film", APPLIED PHYSICS A MATERIALS SCIENCE & PROCESSING, SPRINGER BERLIN HEIDELBERG, BERLIN/HEIDELBERG, vol. 113, no. 2, 13 March 2013 (2013-03-13), pages 347-353, XP035331096, ISSN: 0947-8396, DOI: 10.1007/S00339-013-7652-0 [retrieved on 2013-03-13] * the whole document * | 1,17,18 | |
| Y | US 2015/069240 A1 (TAKAHASHI KOHEI [JP] ET AL) 12 March 2015 (2015-03-12) * abstract; figure 3 * * paragraph [0036] * | 16 | TECHNICAL FIELDS SEARCHED (IPC) H01L G02F |
| A | US 8 829 324 B2 (UNIV NORTHWESTERN [US]) 9 September 2014 (2014-09-09) * abstract; claim 1; figure 2 * * paragraphs [0037] - [0040] * | 1-19 | |

The present search report has been drawn up for all claims

| Place of search | Date of completion of the search | Examiner |
|---|---|---|
| The Hague | 7 October 2021 | Beugin, Anne |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 17 2006

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2021

| Patent document cited in search report | | Publication date | Patent family member(s) | | Publication date |
|---|---|---|---|---|---|
| US 2015069240 | A1 | 12-03-2015 | JP 5607283 B1 | | 15-10-2014 |
| | | | JP WO2014147967 | A1 | 16-02-2017 |
| | | | US 2015069240 | A1 | 12-03-2015 |
| | | | WO 2014147967 | A1 | 25-09-2014 |
| US 8829324 | B2 | 09-09-2014 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P. SHUMYATSKY ; R. R. ALFANO.** *J. Biomed. Opt.,* 2011, vol. 16, 033001
- **H. LENGFELLNER ; S. ZEUNER ; W. PRETTL ; K.F. RENK.** *Europhys. Lett.,* 1994, vol. 25, 375
- **L. R. TESTARDI.** *Appl. Phys. Lett.,* 1994, vol. 64, 2347
- **TH. ZAHNER ; R. SCHREINER ; R. STIERSTORFER ; O. KUS ; S. T. LI ; R. ROESSLER ; J. D. PEDARNIK ; D. BAUERLE ; H. LENGFELLNER.** *Europhys. Lett.,* 1997, vol. 40, 673
- **P. YORDANOV ; W. SIGLE ; P. KAYA ; M. E. GRUNER ; R. PENTCHEVA ; B. KEIMER ; H.-U. HABERMEIER.** *Phys. Rev. Mater.,* 2019, vol. 3, 085403